(19) Europäisches Patentamt
European Patent Office
Office européen des brevets

(11) EP 4 773 742 A1

(12) EUROPEAN PATENT APPLICATION

(43) Date of publication:
08.07.2026 Bulletin 2026/28

(51) International Patent Classification (IPC):
H05K 1/02 (2006.01)    H05K 1/16 (2006.01)
H02M 7/00 (2006.01)

(21) Application number: 25214661.8

(22) Date of filing: 10.11.2025

(52) Cooperative Patent Classification (CPC):
H05K 1/0262; H02M 7/003; H05K 1/165;
H01F 2027/2809; H05K 1/0298; H05K 2201/073

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 06.01.2025 US 202519010390

(71) Applicant: Borgwarner Inc.
Auburn Hills, Michigan 48326 (US)

(72) Inventors:
• GONA, Lokesh
  Fishers, IN (US)
• ZARABADI, Seyed R.
  Kokomo, IN (US)

(74) Representative: Office Freylinger
P.O. Box 48
8001 Strassen (LU)

(54) SYSTEMS AND METHODS FOR GALVANIC ISOLATOR WITH PRINTED CIRCUIT BOARD

(57) A system includes an inverter configured to convert DC power from a battery to AC power to drive a motor, wherein the inverter includes: a galvanic isolator separating a high voltage area of the inverter from a low voltage area of the inverter; a low voltage controller in the low voltage area; and a high voltage controller in the high voltage area and configured to communicate with the low voltage controller via the galvanic isolator, wherein the galvanic isolator includes: a printed circuit board (PCB) including a substrate having a high voltage side defining the high voltage area and a low voltage side defining the low voltage area, a low voltage metal trace on the low voltage side of the substrate and connected to the low voltage controller, and a high voltage metal trace on the high voltage side of the substrate and connected to the high voltage controller.

400

FIG. 4

EP 4 773 742 A1

## Description

## TECHNICAL FIELD

Various embodiments of the present disclosure relate generally to systems and methods for galvanic isolation and, more particularly, to a printed circuit board including metal traces for galvanic isolation.

## BACKGROUND

Inverters, such as those used to drive a motor in an electric vehicle, for example, are responsible for converting High Voltage Direct Current (HVDC) into Alternating Current (AC) to drive the motor. The presence of high voltages and switching devices can introduce significant potential differences in power electronic system operating in multiple voltage domains, requiring a way to send information without a direct path for the electrical current across different voltage domains.

The present disclosure is directed to overcoming one or more of these above-referenced challenges.

## SUMMARY OF THE DISCLOSURE

In some aspects, the techniques described herein relate to a system including an inverter configured to convert DC power from a battery to AC power to drive a motor, wherein the inverter includes: a galvanic isolator separating a high voltage area of the inverter from a low voltage area of the inverter; a low voltage controller in the low voltage area; and a high voltage controller in the high voltage area and configured to communicate with the low voltage controller via the galvanic isolator, wherein the galvanic isolator includes: a printed circuit board (PCB) including a substrate having a high voltage side defining the high voltage area and a low voltage side defining the low voltage area, a low voltage metal trace on the low voltage side of the substrate and connected to the low voltage controller, and a high voltage metal trace on the high voltage side of the substrate and connected to the high voltage controller.

In some aspects, the techniques described herein relate to a system, wherein the substrate includes one or more layers, wherein at least one layer of the one or more layers includes a dielectric material.

In some aspects, the techniques described herein relate to a system, wherein a thickness of the dielectric material is $555\mu$m.

In some aspects, the techniques described herein relate to a system, wherein the high voltage metal trace has a first shape and the low voltage metal trace has a second shape, wherein the first shape is substantially similar to the second shape.

In some aspects, the techniques described herein relate to a system, wherein the high voltage metal trace is not connected to the low voltage metal trace by a direct electrical current path.

In some aspects, the techniques described herein relate to a system, wherein the high voltage metal trace has a first outer diameter and the low voltage metal trace has a second outer diameter, wherein the first outer diameter is substantially similar to the second outer diameter.

In some aspects, the techniques described herein relate to a system, further including: the battery configured to supply the DC power to the inverter; and the motor configured to receive the AC power from the inverter to drive the motor.

In some aspects, the techniques described herein relate to a printed circuit board (PCB) including: a substrate having a high voltage side defining a high voltage area and a low voltage side defining a low voltage area; a low voltage metal trace on the low voltage side of the substrate; and a high voltage metal trace on the high voltage side of the substrate.

In some aspects, the techniques described herein relate to a PCB, wherein the substrate includes one or more layers.

In some aspects, the techniques described herein relate to a PCB, wherein the one or more layers include a dielectric layer.

In some aspects, the techniques described herein relate to a PCB, wherein a thickness of the dielectric layer is configured to insulate the low voltage side from the high voltage side.

In some aspects, the techniques described herein relate to a PCB, wherein an outer diameter of the low voltage metal trace is 2mm and an outer diameter of the high voltage metal trace is 2mm.

In some aspects, the techniques described herein relate to a PCB, wherein a number of turns of the low voltage metal trace is 2 and a number of turns of the high voltage metal trace is 2.

In some aspects, the techniques described herein relate to a PCB, wherein the low voltage metal trace is circular and the high voltage metal trace is circular.

In some aspects, the techniques described herein relate to a galvanic isolator for a power converter, the galvanic isolator including: a dielectric layer including a first side and a second side; a first layer including a first coupled coil, the first layer on the first side of the dielectric layer; and a second layer including a second coupled coil, the second layer on the second side of the dielectric layer, wherein the second coupled coil is configured to be electro-magnetically coupled with the first coupled coil.

In some aspects, the techniques described herein relate to a galvanic isolator, wherein the first coupled coil is configured to operate in a first voltage domain, and the second coupled coil is configured to operate in a second voltage domain different from the first voltage domain.

In some aspects, the techniques described herein relate to a galvanic isolator, wherein the first voltage domain is approximately 5V and the second voltage domain is approximately 800V.

In some aspects, the techniques described herein relate to a galvanic isolator, wherein the dielectric layer includes a dielectric relative permittivity of approximately 4.2.

In some aspects, the techniques described herein relate to a galvanic isolator, wherein the dielectric layer includes a dielectric relative permeability of approximately 1.

In some aspects, the techniques described herein relate to a galvanic isolator, wherein the first coupled coil and the second coupled coil have an inductance of approximately 11nH.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

## BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.

FIG. 1 depicts an exemplary system infrastructure for a vehicle including a combined inverter and converter, according to one or more embodiments.

FIG. 2 depicts an exemplary system infrastructure for the combined inverter and converter of FIG. 1, according to one or more embodiments.

FIG. 3 depicts an exemplary system infrastructure for the controller of FIG. 2, according to one or more embodiments.

FIG. 4 depicts an exemplary printed circuit board (PCB) including a galvanic isolator, according to one or more embodiments.

FIG. 5 depicts an exemplary galvanic isolator, according to one or more embodiments.

FIG. 6 depicts an exemplary circuit including a galvanic isolator, according to one or more embodiments.

FIG. 7 depicts an exemplary data communication system including a galvanic isolator, according to one or more embodiments.

## DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of $\pm 10\%$ in the stated value. In this disclosure, unless stated otherwise, any numeric value may include a possible variation of $\pm 10\%$ in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section.

Various embodiments of the present disclosure relate generally to systems and methods for galvanic isolation and, more particularly, to a printed circuit board including metal traces for galvanic isolation.

The presence of high voltages and switching devices can introduce significant potential differences in power electronic systems operating in multiple voltage domains, which may result in safety hazards, errors in communication, and/or common mode voltage transients. To overcome the above listed results, there is a need for sending information without a direct path for the electrical current across different voltage domains. Signals and data transmission across various domains are galvanically isolated using high voltage integrated capacitors, transformers, and opto-couplers. Opto-couplers are typically not used in automotive application due to low reliability and slow response times. These devices may be used to meet various isolation requirements specified by the standards, for example, basic isolation, double isolation, and reinforced isolation.

Some methods for signal and data communication across two voltage domains may be accomplished using fully integrated solutions. For example, fully integrated solutions may include a specialized integrated circuit (IC) fabrication process to create devices that may withstand high voltages. Fully integrated solutions may include a custom packaging and lead-frame to withstand high voltage and provide sufficient creepage and clearance distances. Fully integrated solutions may include a unique IC design and a process that is optimized for varying isolation requirements (e.g., basic, double, and reinforcement), or component level isolation testing and qualification. All of these factors may contribute to significantly higher cost and may provide less flexibility.

One or more embodiments may avoid expensive and inflexible high voltage galvanic isolation for signal communication (e.g., power and/or data) across different voltage domains. One or more embodiments may provide small couple printed circuit board (PCB) traces separated by dielectric layers, along with a transceiver for robust signal communication across the isolated coupled traces. One or more embodiments may provide a low cost and highly flexible solution.

A PCB may include multiple metal layers separated by dielectric materials. PCB metal traces may be shaped to create magnetically couple coils. Each coil may interface to circuitry in one voltage domain. The coupled coils may be separated by one or more dielectric layers and provide sufficient breakdown voltage strength as required by the standards. Magnetic coupling of the coils may provide a structure to transfer information and/or power from one voltage domain to another with no direct electrical current path. PCB metal traces may be used to create magnetically coupled resonant networks, permitting robust data communication between voltage domains, which may provide a number of advantages. For example, providing significantly lower cost and higher flexibility, one or more embodiments may include: a low voltage wafer process, a standard packaging and leadframe, sufficient PCB dielectric thickness between coupled traces providing required breakdown voltage strength for basic and reinforced isolation. These advantages may allow more freedom in placement of ICs in different voltage domains because the coupled coils may not be included in a single package. One or more embodiments may provide higher performance due to the PCB traces having a small manufacturing variations, and/or proper and less complex transceiver design, which may provide robust communication in the presence of device parasitics, common mode transient immunity (CMTI) signal(s), and radio-frequency interference (RFI) noise.

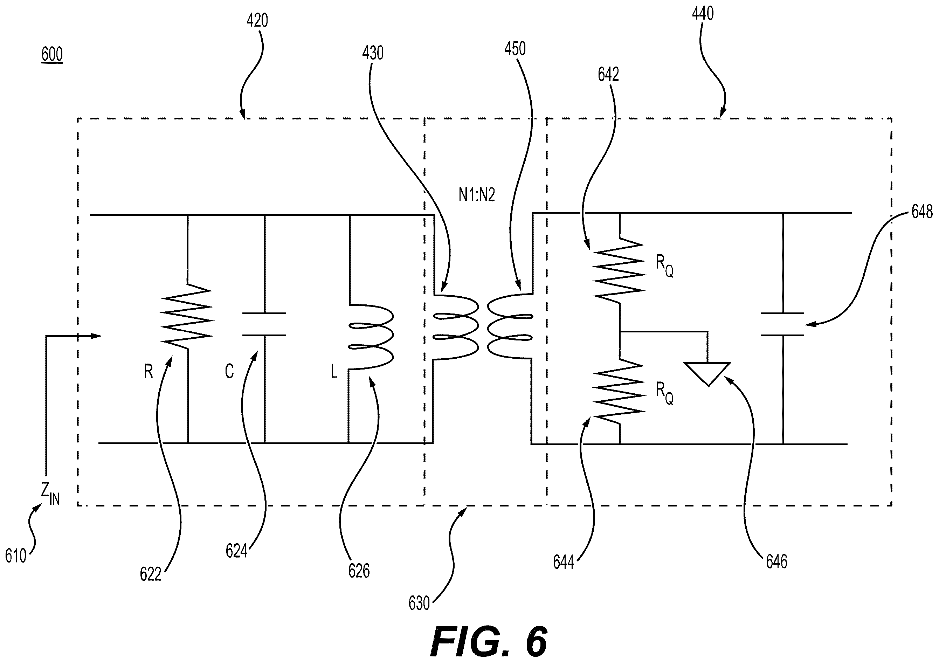

The magnetically coupled coils may be constructed of copper traces. However, other materials (e.g., aluminum, nickel, silver, gold, or the like) may be used. The PCB may include 6-layers, including a dielectric layer constructed of FR4, for example. The number of layers of the PCB and the material used as a dielectric may vary based on the application. For example, the following geometric parameters may be used for the coil traces. The coil trace may include a trace width of approximately 80$\mu$m, a material (e.g., copper) thickness of approximately 1oz, approximately two turns in each coil, an outer diameter of approximately 2mm for each coil trace, a dielectric thickness between the coil traces of approximately 555$\mu$m, a dielectric permittivity of approximately 4.2, and a dielectric permeability of approximately 1. The result of the geometric parameters may result in an inductance in each coil trace of approximately 11nH, coupling coefficient of approximately 0.18, and a dielectric strength of approximately 16kV. In an embodiment, an interface design may include a coupled network constructed by connecting parallel resistors and capacitor components across each PCB coil, with an overall electrical equivalent circuit as described in more in detail below with respect to FIG. 6.

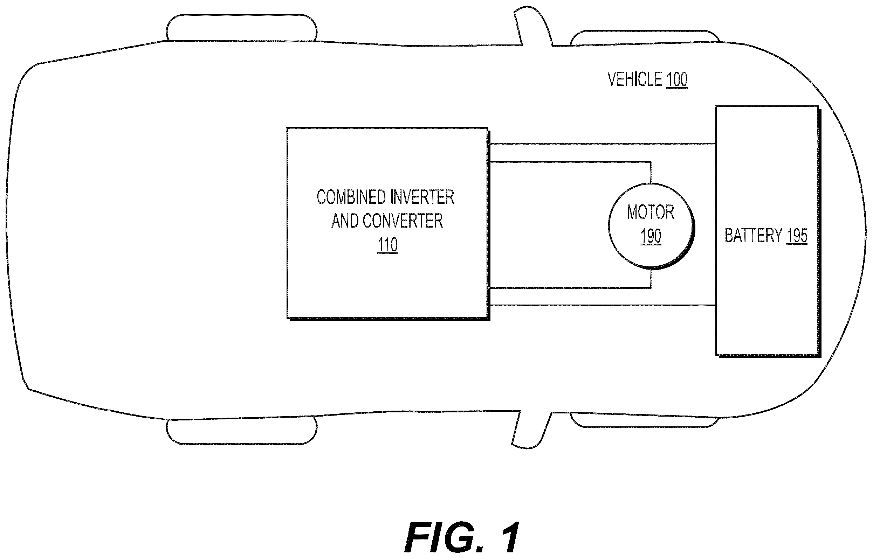

FIG. 1 depicts an exemplary system infrastructure for a vehicle including a combined inverter and converter, according to one or more embodiments. In the context of this disclosure, the combined inverter and converter may be referred to as an inverter. As shown in FIG. 1, electric vehicle 100 may include an inverter 110, a motor 190, and a battery 195. The inverter 110 may include components to receive electrical power from an external source and output electrical power to charge battery 195 of electric vehicle 100. The inverter 110 may convert DC power from battery 195 in electric vehicle 100 to AC power, to drive motor 190 of the electric vehicle 100, for example, but the embodiments are not limited thereto. The inverter 110 may be bidirectional, and may convert DC power to AC power, or convert AC power to DC power, such as during regenerative braking, for example. Inverter 110 may be a three-phase inverter, a single-phase inverter, or a multi-phase inverter.

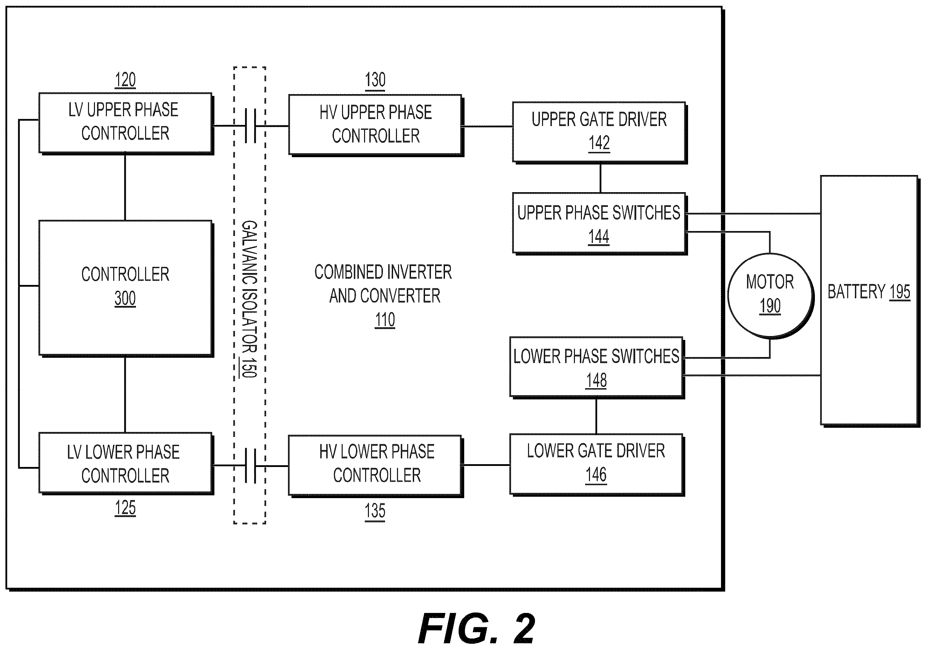

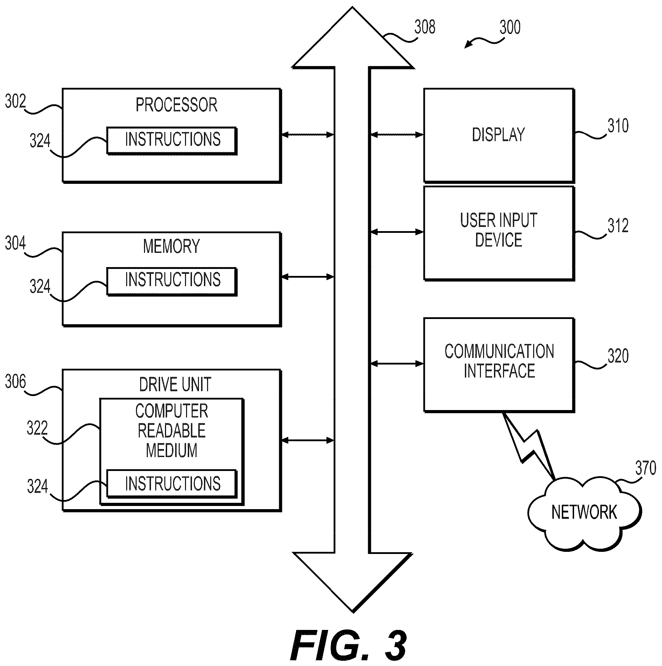

FIG. 2 depicts an exemplary system infrastructure for the inverter 110 of FIG. 1, according to one or more embodiments. Electric vehicle 100 may include inverter 110, motor 190, and battery 195. Inverter 110 may include an inverter controller 300 (shown in FIG. 3) to control the inverter 110. Inverter 110 may include an LV upper phase controller 120 separated from an HV upper phase controller 130 by a galvanic isolator 150. Inverter 110 may include an LV lower phase controller 125 separated from an HV lower phase controller 135 by galvanic isolator 150. Inverter 110 may include an HV upper phase controller 130 including a gate driver power supply, an upper gate driver 142, and upper phase switches 144. Inverter 110 may include an HV lower phase controller 135 including a gate driver power supply, a lower gate driver 146, and lower phase switches 148. Upper phase switches 144 and lower phase switches 148 may be connected to motor 190 and battery 195.

Inverter 110 may include an LV area, where voltages are generally less than 5V, for example, and an HV area, where voltages may exceed 500V, for example. The LV area may be separated from the HV area by galvanic isolator 150. Inverter controller 300 may be in the LV area of inverter 110, and may send signals to and receive signals from LV upper phase controller 120. LV upper phase controller 120 may be in the LV area of inverter 110, and may send signals to and receive signals from HV upper phase controller 130.

LV upper phase controller 120 may send signals to and receive signals from LV lower phase controller 125. HV upper phase controller 130 may be in the HV area of inverter 110. Accordingly, signals between LV upper phase controller 120 and HV upper phase controller 130 pass through galvanic isolator 150. HV upper phase controller 130 may send signals to and receive signals from the upper gate driver 142. The upper gate driver 142 may send signals to and receive signals from the upper phase switches 144.

Upper phase switches 144 may be connected to motor 190 and battery 195. Upper phase switches 144 and lower phase switches 148 may be used to transfer energy from motor 190 to battery 195, from battery 195 to motor 190, from an external source to battery 195, or from battery 195 to an external source, for example. The lower phase system of inverter 110 may be similar to the upper phase system as described above.

FIG. 3 depicts an exemplary system infrastructure for inverter controller 300 of FIG. 2, according to one or more embodiments. Inverter controller 300 may include one or more controllers.

The inverter controller 300 may include a set of instructions that can be executed to cause the inverter controller 300 to perform any one or more of the methods or computer based functions disclosed herein. The inverter controller 300 may operate as a standalone device or may be connected, e.g., using a network, to other computer systems or peripheral devices.

In a networked deployment, the inverter controller 300 may operate in the capacity of a server or as a client in a server-client user network environment, or as a peer computer system in a peer-to-peer (or distributed) network environment. The inverter controller 300 can also be implemented as or incorporated into various devices, such as a personal computer (PC), a tablet PC, a set-top box (STB), a personal digital assistant (PDA), a mobile device, a palmtop computer, a laptop computer, a desktop computer, a communications device, a wireless telephone, a land-line telephone, a control system, a camera, a scanner, a facsimile machine, a printer, a pager, a personal trusted device, a web appliance, a network router, switch or bridge, or any other machine capable of executing a set of instructions (sequential or otherwise) that specify actions to be taken by that machine. In a particular implementation, the inverter controller 300 can be implemented using electronic devices that provide voice, video, power, or data communication. Further, while the inverter controller 300 is illustrated as a single system, the term "system" shall also be taken to include any collection of systems or sub-systems that individually or jointly execute a set, or multiple sets, of instructions to perform one or more computer functions.

As shown in FIG. 3, the inverter controller 300 may include a processor 302, e.g., a central processing unit (CPU), a graphics processing unit (GPU), or both. The processor 302 may be a component in a variety of systems. For example, the processor 302 may be part of a standard inverter. The processor 302 may be one or more general processors, digital signal processors, application specific integrated circuits, field programmable gate arrays, servers, networks, digital circuits, analog circuits, combinations thereof, or other now known or later developed devices for analyzing and processing data. The processor 302 may implement a software program, such as code generated manually (i.e., programmed).

The inverter controller 300 may include a memory 304 that can communicate via a bus 308. The memory 304 may be a main memory, a static memory, or a dynamic memory. The memory 304 may include, but is not limited to computer readable storage media such as various types of volatile and non-volatile storage media, including but not limited to random access memory, read-only memory, programmable read-only memory, electrically programmable read-only memory, electrically erasable read-only memory, flash memory, magnetic tape or disk, optical media and the like. In one implementation, the memory 304 includes a cache or random-access memory for the processor 302. In alternative implementations, the memory 304 is separate from the processor 302, such as a cache memory of a processor, the system memory, or other memory. The memory 304 may be an external storage device or database for storing data. Examples include a hard drive, compact disc ("CD"), digital video disc ("DVD"), memory card, memory stick, floppy disc, universal serial bus ("USB") memory device, or any other device operative to store data. The memory 304 is operable to store instructions executable by the processor 302. The functions, acts or tasks illustrated in the figures or described herein may be performed by the processor 302 executing the instructions stored in the memory 304. The functions, acts or tasks are independent of the particular type of instructions set, storage media, processor or processing strategy and may be performed by software, hardware, integrated circuits, firmware, micro-code and the like, operating alone or in combination.

Likewise, processing strategies may include multiprocessing, multitasking, parallel processing and the like.

As shown, the inverter controller 300 may further include a display 310, such as a liquid crystal display (LCD), an organic light emitting diode (OLED), a flat panel display, a solid-state display, a cathode ray tube (CRT), a projector, a printer or other now known or later developed display device for outputting determined information. The display 310 may act as an interface for the user to see the functioning of the processor 302, or specifically as an interface with the software stored in the memory 304 or in the drive unit 306.

Additionally or alternatively, the inverter controller 300 may include an input device 312 configured to allow a user to interact with any of the components of inverter controller 300. The input device 312 may be a number pad, a keyboard, or a cursor control device, such as a mouse, or a joystick, touch screen display, remote control, or any other device operative to interact with the inverter controller 300.

The inverter controller 300 may also or alternatively include drive unit 306 implemented as a disk or optical drive. The drive unit 306 may include a computer-readable medium 322 in which one or more sets of instructions 324, e.g. software, can be embedded. Further, the instructions 324 may embody one or more of the methods or logic as described herein. The instructions 324 may reside completely or partially within the memory 304 and/or within the processor 302 during execution by the inverter controller 300. The memory 304 and the processor 302 also may include computer-readable media as discussed above.

In some systems, a computer-readable medium 322 includes instructions 324 or receives and executes instructions 324 responsive to a propagated signal so that a device connected to a network 370 can communicate voice, video, audio, images, or any other data over the network 370. Further, the instructions 324 may be transmitted or received over the network 370 via a communication port or interface 320, and/or using a bus 308. The communication port or interface 320 may be a part of the processor 302 or may be a separate component. The communication port or interface 320 may be created in software or may be a physical connection in hardware. The communication port or interface 320 may be configured to connect with a network 370, external media, the display 310, or any other components in inverter controller 300, or combinations thereof. The connection with the network 370 may be a physical connection, such as a wired Ethernet connection or may be established wirelessly as discussed below. Likewise, the additional connections with other components of the inverter controller 300 may be physical connections or may be established wirelessly. The network 370 may alternatively be directly connected to a bus 308.

While the computer-readable medium 322 is shown to be a single medium, the term "computer-readable medium" may include a single medium or multiple media, such as a centralized or distributed database, and/or associated caches and servers that store one or more sets of instructions. The term "computer-readable medium" may also include any medium that is capable of storing, encoding, or carrying a set of instructions for execution by a processor or that cause a computer system to perform any one or more of the methods or operations disclosed herein. The computer-readable medium 322 may be non-transitory, and may be tangible.

The computer-readable medium 322 can include a solid-state memory such as a memory card or other package that houses one or more non-volatile read-only memories. The computer-readable medium 322 can be a random-access memory or other volatile re-writable memory. Additionally or alternatively, the computer-readable medium 322 can include a magneto-optical or optical medium, such as a disk or tapes or other storage device to capture carrier wave signals such as a signal communicated over a transmission medium. A digital file attachment to an e-mail or other self-contained information archive or set of archives may be considered a distribution medium that is a tangible storage medium. Accordingly, the disclosure is considered to include any one or more of a computer-readable medium or a distribution medium and other equivalents and successor media, in which data or instructions may be stored.

In an alternative implementation, dedicated hardware implementations, such as application specific integrated circuits, programmable logic arrays and other hardware devices, can be constructed to implement one or more of the methods described herein. Applications that may include the apparatus and systems of various implementations can broadly include a variety of electronic and computer systems. One or more implementations described herein may implement functions using two or more specific interconnected hardware modules or devices with related control and data signals that can be communicated between and through the modules, or as portions of an application-specific integrated circuit. Accordingly, the present system encompasses software, firmware, and hardware implementations.

The inverter controller 300 may be connected to a network 370. The network 370 may define one or more networks including wired or wireless networks. The wireless network may be a cellular telephone network, an 802.11, 802.16, 802.20, or WiMAX network. Further, such networks may include a public network, such as the Internet, a private network, such as an intranet, or combinations thereof, and may utilize a variety of networking protocols now available or later developed including, but not limited to TCP/IP based networking protocols. The network 370 may include wide area networks (WAN), such as the Internet, local area networks (LAN), campus area networks, metropolitan area networks, a direct connection such as through a Universal Serial Bus (USB) port, or any other networks that may allow for data communication. The network 370 may be configured to couple one computing device to another computing device to enable communication of data between the devices. The network 370 may generally be enabled to employ any form of machine-readable media for communicating information from one device to another. The network 370 may include communication methods by which information may travel between computing devices. The network 370 may be divided into sub-networks. The sub-networks may allow access to all of the other components connected thereto or the sub-networks may restrict access between the components. The network 370 may be regarded as a public or private network connection and may include, for example, a virtual private network or an encryption or other security mechanism employed over the public Internet, or the like.

In accordance with various implementations of the present disclosure, the methods described herein may be implemented by software programs executable by a computer system. Further, in an exemplary, non-limited implementation, implementations can include distributed processing, component or object distributed processing, and parallel processing. Alternatively, virtual computer system processing can be constructed to implement one or more of the methods or functionality as described herein.

Although the present specification describes components and functions that may be implemented in particular implementations with reference to particular standards and protocols, the disclosure is not limited to such standards and protocols. For example, standards for Internet and other packet switched network transmission (e.g., TCP/IP, UDP/IP, HTML, HTTP) represent examples of the state of the art. Such standards are periodically superseded by faster or more efficient equivalents having essentially the same functions. Accordingly, replacement standards and protocols having the same or similar functions as those disclosed herein are considered equivalents thereof.

It will be understood that the operations of methods discussed are performed in one embodiment by an appropriate processor (or processors) of a processing (i.e., computer) system executing instructions (computer-readable code) stored in storage. It will also be understood that the disclosure is not limited to any particular implementation or programming technique and that the disclosure may be implemented using any appropriate techniques for implementing the functionality described herein. The disclosure is not limited to any particular programming language or operating system.

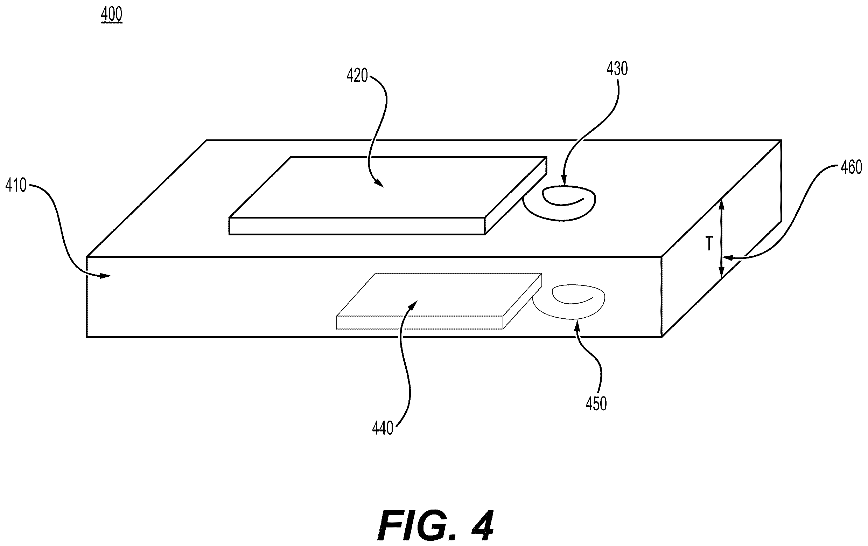

FIG. 4 depicts an exemplary printed circuit board (PCB) including a galvanic isolator, according to one or more embodiments. The galvanic isolator described herein may be a component of inverter 110 (e.g., galvanic isolator 150), or may be used in any system that requires galvanic isolation. The PCB 400 may include a substrate 410, a first controller 420, a first metal trace 430, a second controller 440, and a second metal trace 450. The substrate 410 may include a high voltage side defining a high voltage area (e.g. high voltage domain of approximately 800V) and a low voltage side defining a low voltage area (e.g. low voltage domain of approximately 5V). The substrate 410 may include one or more layers, with at least one of the one or more layers being a dielectric layer.

The substrate 410 including the one or more layers with the dielectric layer may be disposed between the first controller 420 and the second controller 440. The first controller 420 and the first metal trace 430 may be disposed on the high voltage side of the substrate 410. The second controller 440 and the second metal trace 450 may be disposed on the low voltage side of the substrate 410. The dielectric layer may include a dielectric thickness 460 (e.g., T) to insulate the high voltage side from the low voltage side. The dielectric thickness 460 may be approximately $555\mu$, for example. However, the dielectric thickness 460 of the dielectric layer may vary based on one or more of the application, the voltage domains, the dielectric material, the metal trace material, or the like. For example, the dielectric thickness 460, may be any value, depending on the relative permittivity of the dielectric material or the dielectric breakdown strength required to meet the isolation voltage requirements. For example, FR4 dielectric material may include a dielectric breakdown strength of 30kV/mm, requiring a dielectric thickness of at least $400\mu m$ to handle 12kV of voltage across the two voltage domains. With known common manufacturing materials, the range may be greater than $100\mu m$. The dielectric thickness 460 may be from approximately $100\mu m$ to approximately $1500\mu m$. The first controller 420 may be coupled to the first metal trace 430 disposed on high voltage side (e.g., a first side) of the substrate 410. The second controller 440 may be coupled to the second metal trace 450 disposed on the low voltage side (e.g., a second side) of the substrate 410. The first metal trace 430 may be electro-magnetically coupled to the second metal trace 450 through the substrate 410. The first metal trace 430 is not connected to the second metal trace 450 by a direct electrical current path. The first metal trace 430 is separated from the second metal trace 450 by the substrate 410.

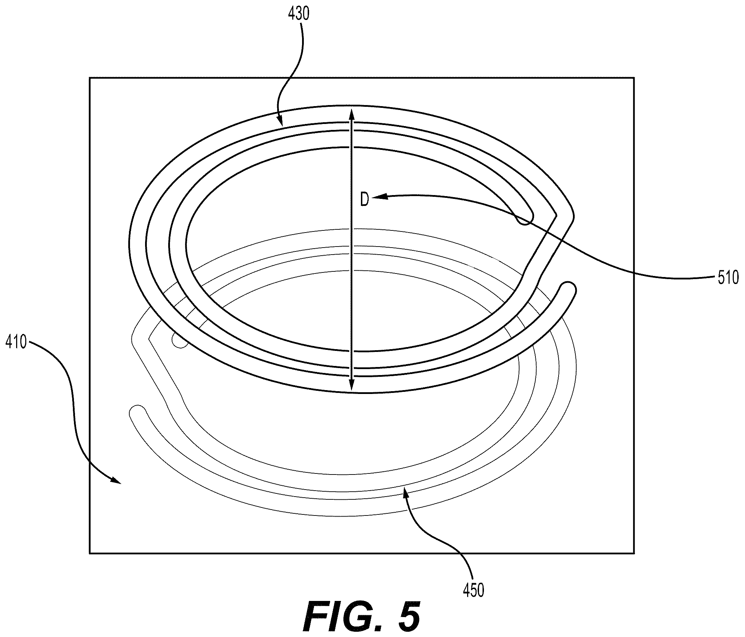

FIG. 5 depicts an exemplary galvanic isolator, according to one or more embodiments. The substrate 410, the first metal trace 430, and the second metal trace 450 may be configured and operable similar to the description above with respect to FIG. 4 except as otherwise described herein. As such, like reference numerals are used to identify similar components. The first metal trace 430 and the second metal trace 450 may include an outer diameter 510 (e.g., D). The outer diameter 510 of the first metal trace 430 may be substantially similar to the outer diameter 510 of the second metal trace 450. The outer diameter 510 of the first metal trace 430 and the outer diameter 510 of the second metal trace 450 may be configured to electro-magnetically couple the first metal trace 430 to the second metal trace 450. The outer diameter 510 of the first metal trace 430 and the outer diameter 510 of the second metal trace 450 may be approximately 2mm. The first metal trace 430 may include a first shape and the second metal trace 450 may include a second shape. The first shape of the first metal trace 430 may be substantially similar to the second shape of the second metal trace 450. The first shape and the second shape may be circular; however, any shape (e.g., square, triangle, or the like) may be used. The first metal trace 430 and the second metal trace 450 may include one or more turns (e.g., 2 turns as depicted). However, any number of turns may be used to provide the desired inductance and coupling coefficient as discussed below with respect to FIG. 6.

FIG. 6 depicts an exemplary circuit including a galvanic isolator, according to one or more embodiments. Interface design 600 may include an input impedance 610, the first controller 420, a galvanic isolator 630, and the second controller 440. The first controller 420 may include a resistor 622, a capacitor 624, and an inductor 626. The capacitances (e.g., capacitor 624) and inductances (e.g., inductor 626) may either represent a lumped electrical circuit of the galvanic isolator 630, and/or may represent a lumped electrical circuit of the galvanic isolator "plus" additional inductances/capacitances/resistances added to a network to achieve a desired complex impedance of $Z_{in}$ for maximum power transfer between the transmit-side and the receive-side. The first controller 420 may be constructed by connecting parallel resistor (e.g., resistor 622) and capacitor (e.g., capacitor 624) components across each metal trace (e.g., first metal trace 430 and second metal trace 450). The galvanic isolator 630 may include the first metal trace 430 and the second metal trace 450. The second controller 440 may include a first resistor 642, a second resistor 644, a ground connection 646, and a first capacitor 648. The components of the second controller 440 may define a frequency tuned balanced differential amplifier configured to reduce CMTI and **RFI** noise.

The input impedance 610 of the interface design 600 may be defined by the following equations:

Equation 1.
$$Z_{in} = \frac{R}{(1+(wRC-\frac{R}{wL})^2)^{0.5}}$$

Equation 2.
$$Q_O = \frac{R||R'_Q}{Z_O}$$

Equation 3.
$$Z_O = \frac{1}{wC} = wL = \sqrt{\frac{L}{C}}$$

In Equations 1, 2, and 3, the constant $w = (1/LC)^{0.5}$ and the frequency is $f_r=w/2\pi$, approximately 500MHz. In addition to the equations above, interface design 600 may include a set of parameters described below. The interface design 600 may include the PCB 400 including 6 layers, the dielectric layer of the substrate 410 is made of FR4 dielectric material, and the first metal trace 430 and the second metal trace 450 may be made of copper. The trace width of the first metal trace 430 and the second metal trace 450 may be approximately 80$\mu$ with a thickness of approximately 1oz. The outer diameter 510 of the first metal trace 430 and the second metal trace 450 may be approximately 2mm. The dielectric layer may include the dielectric thickness 460 of approximately 555$\mu$m with a relative permittivity and permeability of approximately 4.2 and approximately 1, respectively. The result of the parameters as described above result in an inductance in the first metal trace 430 and the second metal trace 450 of approximately 11nH, a coupling coefficient of approximately 0.18, and a dielectric strength of approximately 16kV. As a result, a magnitude response of the first metal trace 430 and the second metal trace 450 may include a first resonant frequency of approximately 519MHz with a parasitic resonance at approximately 3.25GHz and approximately 6.78GHz. The parasitic resonance may be reduced with the second controller 440 including tuning elements.

The parameters as described above may be one example of parameters to perform the method as described herein. However, different parameters may be employed depending on the application, the inductance, the coupling coefficient, and the dielectric strength required.

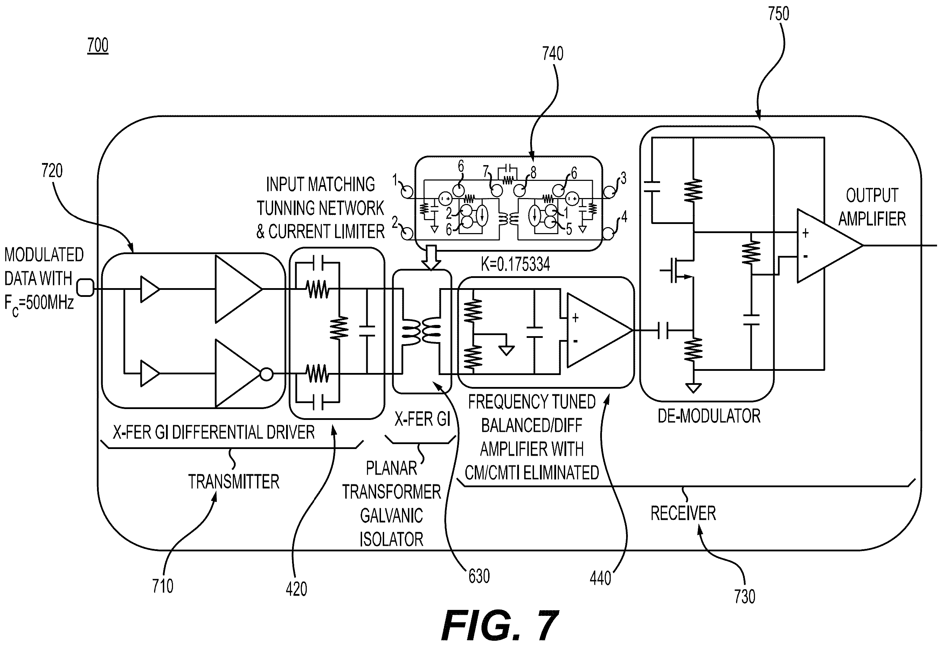

FIG. 7 depicts an exemplary data communication system including a galvanic isolator, according to one or more embodiments. Block diagram 700 may include transmitter 710, galvanic isolator 630, and receiver 730. Transmitter 710 may include differential driver 720 and first controller 420. Differential driver 720 may be configured to receive a carrier signal at a predefined frequency (e.g., approximately 500MHz) to be transmitted to the first controller 420. The carrier signal passed through the differential driver 720 received by the first controller 420 may be the input impedance 610 as described with reference to FIG. 6 above. The galvanic isolator 630 may include a galvanic interface 740 configured to transfer power from the high voltage domain to the low voltage domain in order to transmit data from the high voltage domain to the low voltage domain or vice versa. The receiver 730 may include the second controller 440 and a demodulator 750. The receiver 730 may be configured to receive the data transmitted from the high voltage domain to the low voltage domain. The second controller 440 may include a frequency tuned balanced differential amplifier to reduce CM/CMTI/RFI noise. The de-modulator 750 may be configured to extract data from the carrier signal for use in the low voltage domain.

One or more embodiments may avoid expensive and inflexible high voltage galvanic isolation for signal communication across different voltage domains. One or more embodiments may provide small couple printed circuit board (PCB) traces separated by dielectric layers, along with a transceiver for robust signal communication across the isolated coupled traces. One or more embodiments may provide a low cost and highly flexible solution.

Other embodiments of the disclosure will be apparent to those skilled in the art from consideration of the specification and practice of the invention disclosed herein. It is intended that the specification and examples be considered as exemplary only, with a true scope of the invention being indicated by the following claims.

**Claims**

1. A system comprising an inverter configured to convert DC power from a battery to AC power to drive a motor, wherein the inverter includes:

   a galvanic isolator separating a high voltage area of the inverter from a low voltage area of the inverter;
   a low voltage controller in the low voltage area; and
   a high voltage controller in the high voltage area and configured to communicate with the low voltage controller via the galvanic isolator,
   wherein the galvanic isolator includes:
   a printed circuit board (PCB) including a substrate having a high voltage side defining the high voltage area and a low voltage side defining the low voltage area, a low voltage metal trace on the low voltage side of the substrate and connected to the low voltage controller, and a high voltage metal trace on the high voltage side of the substrate and connected to the high voltage controller.

2. The system of claim 1, wherein the substrate includes one or more layers, wherein at least one layer of the one or more layers includes a dielectric material;
   and wherein a thickness of the dielectric material is preferably 555$\mu$m.

3. The system of any one of claims 1 to 2, wherein the high voltage metal trace has a first shape and the low voltage metal trace has a second shape, wherein the first shape is substantially similar to the second shape;
   and wherein, preferably, the high voltage metal trace is not connected to the low voltage metal trace by a direct electrical current path.

4. The system of any one of claims 1 to 3, wherein the high voltage metal trace has a first outer diameter and the low voltage metal trace has a second outer diameter, wherein the first outer diameter is substantially similar to the second outer diameter.

5. The system of any one of claims 1 to 4, further comprising:

   the battery configured to supply the DC power to the inverter; and
   the motor configured to receive the AC power from the inverter to drive the motor.

6. A printed circuit board (PCB) comprising:

   a substrate having a high voltage side defining a high voltage area and a low voltage side defining a low voltage area;
   a low voltage metal trace on the low voltage side of the substrate; and
   a high voltage metal trace on the high voltage side of the substrate.

7. The PCB of claim 6, wherein the substrate includes one or more layers.

8. The PCB of claim 7, wherein the one or more layers include a dielectric layer;
   and wherein a thickness of the dielectric layer is preferably configured to insulate the low voltage side from the high voltage side.

9. The PCB of any one of claims 6 to 8, wherein an outer diameter of the low voltage metal trace is 2mm and an outer diameter of the high voltage metal trace is 2mm.

10. The PCB of any one of claims 6 to 9, wherein a number of turns of the low voltage metal trace is 2 and a number of turns of the high voltage metal trace is 2.

11. The PCB of any one of claims 6 to 10, wherein the low voltage metal trace is circular and the high voltage metal trace is circular.

12. A galvanic isolator for a power converter, the galvanic isolator comprising:

a dielectric layer including a first side and a second side;
a first layer including a first coupled coil, the first layer on the first side of the dielectric layer; and
a second layer including a second coupled coil, the second layer on the second side of the dielectric layer, wherein the second coupled coil is configured to be electro-magnetically coupled with the first coupled coil.

13. The galvanic isolator of claim 12, wherein the first coupled coil is configured to operate in a first voltage domain, and the second coupled coil is configured to operate in a second voltage domain different from the first voltage domain; and preferably wherein the first voltage domain is approximately 5V and the second voltage domain is approximately 800V.

14. The galvanic isolator of any one of claims 12 to 13, wherein the dielectric layer includes a dielectric relative permittivity of approximately 4.2; and/or wherein the dielectric layer includes a dielectric relative permeability of approximately 1.

15. The galvanic isolator of any one of claims 12 to 14, wherein the first coupled coil and the second coupled coil have an inductance of approximately 11nH.

VEHICLE 100

COMBINED INVERTER AND CONVERTER 110

MOTOR 190

BATTERY 195

FIG. 1

EP 4 773 742 A1

*FIG. 2*

**FIG. 3**

EP 4 773 742 A1

400

420

430

410

460

T

440

450

**FIG. 4**

*FIG. 5*

**FIG. 6**

**FIG. 7**

**EUROPEAN SEARCH REPORT**

Application Number

EP 25 21 4661

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2024/103045 A1 (VIJAYKUMAR SRIKANTH [US] ET AL) 28 March 2024 (2024-03-28) * paragraph [0061] - paragraph [0062] * * figure 2 * | 1-5 | INV. H05K1/02 H05K1/16 H02M7/00 |
| X | US 2010/020448 A1 (NG GEK YONG [SG] ET AL) 28 January 2010 (2010-01-28) | 6-9, 11-15 | |
| Y | * paragraph [0039] - paragraph [0052] * * figures 1, 2 * | 1-5,10 | |
| X | US 2015/357113 A1 (SCHOLZ PETER [DE]) 10 December 2015 (2015-12-10) | 6-9, 11-15 | |
| Y | * paragraph [0008] - paragraph [0012] * * paragraph [0018] - paragraph [0022] * * figures 1, 2 * | 1-5,10 | |
| X | US 10 818 568 B1 (HUANG PEI-LUN [TW] ET AL) 27 October 2020 (2020-10-27) * figure 9 * * column 11, line 11 - line 48 * | 6,12 | |
| X | US 2022/399153 A1 (MUKHERJEE SATYAKI [US] ET AL) 15 December 2022 (2022-12-15) * figures 3, 4 * * paragraph [0038] - paragraph [0045] * | 6,12 | TECHNICAL FIELDS SEARCHED (IPC) H05K H01F H02M |
| X | US 2019/372474 A1 (MAO SAIJUN [CN] ET AL) 5 December 2019 (2019-12-05) * paragraph [0019] - paragraph [0026] * * figure 2 * | 6,12 | |
| Y | US 2016/307840 A1 (BONIFIELD THOMAS DYER [US] ET AL) 20 October 2016 (2016-10-20) * paragraph [0045] - paragraph [0051] * * figure 3 * | 10 | |

The present search report has been drawn up for all claims

| Place of search | Date of completion of the search | Examiner |
|---|---|---|
| The Hague | 15 April 2026 | Cornelussen, Ronald |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 21 4661

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2026

| Patent document cited in search report | | Publication date | Patent family member(s) | | Publication date |
|---|---|---|---|---|---|
| US 2024103045 | A1 | 28-03-2024 | CN | 119768913 A | 04-04-2025 |
| | | | CN | 119769029 A | 04-04-2025 |
| | | | CN | 119790595 A | 08-04-2025 |
| | | | CN | 119790596 A | 08-04-2025 |
| | | | CN | 119817034 A | 11-04-2025 |
| | | | CN | 119836743 A | 15-04-2025 |
| | | | CN | 119895566 A | 25-04-2025 |
| | | | CN | 119895716 A | 25-04-2025 |
| | | | CN | 119895717 A | 25-04-2025 |
| | | | CN | 119895718 A | 25-04-2025 |
| | | | CN | 119895719 A | 25-04-2025 |
| | | | CN | 119895720 A | 25-04-2025 |
| | | | CN | 119895721 A | 25-04-2025 |
| | | | CN | 119908065 A | 29-04-2025 |
| | | | CN | 119908071 A | 29-04-2025 |
| | | | CN | 119908072 A | 29-04-2025 |
| | | | CN | 119948744 A | 06-05-2025 |
| | | | CN | 119948749 A | 06-05-2025 |
| | | | CN | 119999061 A | 13-05-2025 |
| | | | CN | 119999093 A | 13-05-2025 |
| | | | EP | 4595106 A1 | 06-08-2025 |
| | | | EP | 4595107 A1 | 06-08-2025 |
| | | | EP | 4595194 A1 | 06-08-2025 |
| | | | EP | 4595199 A1 | 06-08-2025 |
| | | | EP | 4595200 A1 | 06-08-2025 |
| | | | EP | 4595203 A1 | 06-08-2025 |
| | | | EP | 4595213 A1 | 06-08-2025 |
| | | | EP | 4595214 A1 | 06-08-2025 |
| | | | EP | 4595215 A1 | 06-08-2025 |
| | | | EP | 4595216 A1 | 06-08-2025 |
| | | | EP | 4595217 A1 | 06-08-2025 |
| | | | EP | 4595218 A1 | 06-08-2025 |
| | | | EP | 4595219 A1 | 06-08-2025 |
| | | | EP | 4595220 A1 | 06-08-2025 |
| | | | EP | 4595221 A1 | 06-08-2025 |
| | | | EP | 4595222 A1 | 06-08-2025 |
| | | | EP | 4595223 A1 | 06-08-2025 |
| | | | EP | 4595224 A1 | 06-08-2025 |
| | | | EP | 4595225 A1 | 06-08-2025 |
| | | | EP | 4595226 A1 | 06-08-2025 |
| | | | US | 11718190 B1 | 08-08-2023 |
| | | | US | 2024100954 A1 | 28-03-2024 |
| | | | US | 2024100963 A1 | 28-03-2024 |
| | | | US | 2024100966 A1 | 28-03-2024 |
| | | | US | 2024100968 A1 | 28-03-2024 |
| | | | US | 2024100979 A1 | 28-03-2024 |

EPO FORM P0459

For more details about this annex : see Official Journal of the European Patent Office, No. 12/82

page 1 of 3

## ANNEX TO THE EUROPEAN SEARCH REPORT
## ON EUROPEAN PATENT APPLICATION NO.

EP 25 21 4661

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2026

| Patent document cited in search report | Publication date | Patent family member(s) | Publication date |
|---|---|---|---|
| | | US 2024103045 A1 | 28-03-2024 |
| | | US 2024103559 A1 | 28-03-2024 |
| | | US 2024105533 A1 | 28-03-2024 |
| | | US 2024105534 A1 | 28-03-2024 |
| | | US 2024105547 A1 | 28-03-2024 |
| | | US 2024105552 A1 | 28-03-2024 |
| | | US 2024105553 A1 | 28-03-2024 |
| | | US 2024105684 A1 | 28-03-2024 |
| | | US 2024106319 A1 | 28-03-2024 |
| | | US 2024106323 A1 | 28-03-2024 |
| | | US 2024106337 A1 | 28-03-2024 |
| | | US 2024106338 A1 | 28-03-2024 |
| | | US 2024106339 A1 | 28-03-2024 |
| | | US 2024106346 A1 | 28-03-2024 |
| | | US 2024106347 A1 | 28-03-2024 |
| | | US 2024106350 A1 | 28-03-2024 |
| | | US 2024106352 A1 | 28-03-2024 |
| | | US 2024106353 A1 | 28-03-2024 |
| | | US 2024106354 A1 | 28-03-2024 |
| | | US 2024106368 A1 | 28-03-2024 |
| | | US 2024106369 A1 | 28-03-2024 |
| | | US 2024106370 A1 | 28-03-2024 |
| | | US 2024106371 A1 | 28-03-2024 |
| | | US 2024106372 A1 | 28-03-2024 |
| | | US 2024106373 A1 | 28-03-2024 |
| | | US 2024106374 A1 | 28-03-2024 |
| | | US 2024106375 A1 | 28-03-2024 |
| | | US 2024106376 A1 | 28-03-2024 |
| | | US 2024106378 A1 | 28-03-2024 |
| | | US 2024106379 A1 | 28-03-2024 |
| | | US 2024106381 A1 | 28-03-2024 |
| | | US 2024107675 A1 | 28-03-2024 |
| | | US 2024107718 A1 | 28-03-2024 |
| | | US 2024107719 A1 | 28-03-2024 |
| | | US 2024107720 A1 | 28-03-2024 |
| | | US 2024107721 A1 | 28-03-2024 |
| | | US 2024113081 A1 | 04-04-2024 |
| | | US 2024399895 A1 | 05-12-2024 |
| | | US 2025089224 A1 | 13-03-2025 |
| | | US 2025126762 A1 | 17-04-2025 |
| | | US 2025133708 A1 | 24-04-2025 |
| | | US 2025211133 A1 | 26-06-2025 |
| | | US 2025274057 A1 | 28-08-2025 |
| | | US 2025279733 A1 | 04-09-2025 |
| US 2010020448 A1 | 28-01-2010 | DE 102010029470 A1 | 09-12-2010 |

EPO FORM P0459

For more details about this annex : see Official Journal of the European Patent Office, No. 12/82

page 2 of 3

## ANNEX TO THE EUROPEAN SEARCH REPORT
## ON EUROPEAN PATENT APPLICATION NO.

EP 25 21 4661

15-04-2026

| Patent document cited in search report | Publication date | Patent family member(s) | Publication date |
|---|---|---|---|
| | | JP 5456583 B2 | 02-04-2014 |
| | | JP 2010283817 A | 16-12-2010 |
| | | US 2010020448 A1 | 28-01-2010 |
| US 2015357113 A1 | 10-12-2015 | CN 105009235 A | 28-10-2015 |
| | | DE 102013100622 A1 | 24-07-2014 |
| | | EP 2948965 A1 | 02-12-2015 |
| | | US 2015357113 A1 | 10-12-2015 |
| | | WO 2014114584 A1 | 31-07-2014 |
| US 10818568 B1 | 27-10-2020 | CN 112152485 A | 29-12-2020 |
| | | CN 117691882 A | 12-03-2024 |
| | | TW 202103283 A | 16-01-2021 |
| | | US 10818568 B1 | 27-10-2020 |
| US 2022399153 A1 | 15-12-2022 | NONE | |
| US 2019372474 A1 | 05-12-2019 | CN 108512425 A | 07-09-2018 |
| | | EP 3586434 A1 | 01-01-2020 |
| | | US 2019372474 A1 | 05-12-2019 |
| | | WO 2018156934 A1 | 30-08-2018 |
| US 2016307840 A1 | 20-10-2016 | US 2015041190 A1 | 12-02-2015 |
| | | US 2015181706 A1 | 25-06-2015 |
| | | US 2016307840 A1 | 20-10-2016 |

EPO FORM P0459

For more details about this annex : see Official Journal of the European Patent Office, No. 12/82

page 3 of 3